# EUROPÄISCHE PATENTSCHRIFT

(11) **EP 1 345 842 B1**
(45) Veröffentlichungstag und Bekanntmachung des Hinweises auf die Patenterteilung: **02.08.2006**
(21) Anmeldenummer: 01989377.5
(22) Anmeldetag: 06.12.2001
(51) Int. Cl.: B81B 3/00

(54) **Verfahren zur Herstellung eines Halbleiterbauelements sowie ein nach dem Verfahren hergestelltes Halbleiterbauelement, wobei das Halbleiterbauelement insbesondere eine bewegliche Masse aufweist**
Method for producing a semiconductor component having a movable mass in particular, and semiconductor component produced according to this method
Procédé de production d'un composant semi-conducteur et composant semi-conducteur produit selon ce procédé et ayant notamment une masse mobile

(30) Priorität: 22.12.2000 DE 10064494
(43) Veröffentlichungstag der Anmeldung: 24.09.2003
(73) Patentinhaber: ROBERT BOSCH GMBH, 70442 Stuttgart (DE)
(72) Erfinder: BENZEL, Hubert, 72124 Pliezhausen (DE); WEBER, Heribert, 72622 Nuertingen (DE); SCHAEFER, Frank, 72070 Tuebingen (DE)
(86) Internationale Anmeldenummer: PCT/DE2001/004602
(87) Internationale Veröffentlichungsnummer: WO 2002/051741

(56) Entgegenhaltungen:
- EP-A- 0 584 777
- EP-A- 0 895 276
- US-A- 5 352 635
- LANG W ET AL: "Porous silicon: A novel material for microsystems" SENSORS AND ACTUATORS A, ELSEVIER SEQUOIA S.A., LAUSANNE, CH, Bd. 51, Nr. 1, Oktober 1995 (1995-10), Seiten 31-36, XP004303552 ISSN: 0924-4247
- LEHMANN V: "Porous silicon-a new material for MEMS" MICRO ELECTRO MECHANICAL SYSTEMS, 1996, MEMS '96, PROCEEDINGS. AN INVESTIGATION OF MICRO STRUCTURES, SENSORS, ACTUATORS, MACHINES AND SYSTEMS. IEEE, THE NINTH ANNUAL INTERNATIONAL WORKSHOP ON SAN DIEGO, CA, USA 11-15 FEB. 1996, NEW YORK, NY, USA,IEEE, 11. Februar 1996 (1996-02-11), Seiten 1-6, XP010159387 ISBN: 0-7803-2985-6

## Beschreibung

### Stand der Technik

Die Erfindung geht aus von einem Verfahren zur Herstellung eines Halbleiterbauelements, wie insbesondere ein mehrschichtiges Halbleiterbauelement, und von einem verfahrensgemäß hergestellten Halbleiterbauelement, wobei das Halbleiterbauelement insbesondere eine bewegliche Masse bzw. eine Schwingerstruktur aufweist, nach der Gattung des betreffenden unabhängigen Patentanspruchs.

Einige Halbleiterbauelemente, wie insbesondere mikromechanische Beschleunigungssensoren oder Drehratensensoren, weisen eine bewegliche Masse bzw. eine sogenannte Schwingerstruktur auf. Solche Sensoren werden üblicherweise in sogenannter Oberflächen-Mikromechanik aus polykristallinem Silizium hergestellt. Hierbei wird die Schwingerstruktur durch das Wegätzen einer Silizium-Oxid-Opferschicht durch Gasphasenätzen frei beweglich gestaltet.

Die Oberflächen-Mikromechanik zur Herstellung von Beschleunigungssensoren oder Drehratensensoren ist aufwendig und damit teuer. Gegenüber einer Schwingerstruktur aus einkristallinem Silizium lassen sich Schwingerstrukturen aus polykristallinem Silizium nur mit einer größeren Schwankungsbreite in den mechanischen Eigenschaften herstellen. Ferner weisen sie eine schlechtere Langzeitstabilität auf.

Die Prozesse zur Herstellung solcher Sensoren Oberflächen-Mikromechanik sind im allgemeinen nicht mit den typischen Prozessen zur Erzeugung von Halbleiter-Schaltungselementen kompatibel.

Die Veröffentlichung "Free standing mobile 3D porous silicon microstructures", Sensors and Actuators Vol.85 (2000) 356-360 offenbart ein Herstellungsverfahren zur Schaffung mikromechanischer Strukturen mittels porösen Siliziums und Elektropolitur. Die europäische Patentanmeldung EP 0895276 A1 beschreibt ein Herstellungsverfahren zur Schaffung mikromechanischer Strukturen mittels porösen Siliziums, bei dem eine Kaverne aus einer ersten porösen Schicht gebildet wird. Die europäische Patentanmeldung EP 0584777 AI beschreibt die Herstellung poröser Schichten in einem Halbleiter, wobei der Halbleiter in Fluss-Säure schrittweise mit verschieden Stromdichten unterschiedlich lange geätzt wird.

### Vorteile der Erfindung

Das erfindungsgemäße Verfahren mit den kennzeichnenden Merkmalen des betreffenden unabhängigen Patentanspruchs hat demgegenüber insbesondere den Vorteil, daß ein mikromechanisches Bauelement mit einkristallinen Schwingerstrukturen, wie insbesondere ein Beschleunigungssensor oder ein Drehratensensor, einfach und kostengünstig in Oberflächenmikromechanik hergestellt werden kann. Durch die in den abhängigen Patentansprüchen aufgeführten Maßnahmen sind vorteilhafte Weiterbildungen und Verbesserungen des Verfahrens und des Halbleiterbauelements nach den betreffenden unabhängigen Patentansprüchen ermöglicht.

Ein wesentlicher Aspekt der Erfindung besteht darin, eine Kaverne bzw. einen Hohlraum in einem Halbleitersubstrat, wie insbesondere in einem Siliziumsubstrat, mit einem Ätzmedium zu schaffen. Hierzu wird die Deckschicht des Substrats im Bereich der nachfolgend erzeugten Kaverne derart geätzt, daß in dieser Öffnungen bzw. Ätzöffnungen, wie insbesondere Poren bzw. Hohlräume, entstehen. Über die Ätzöffnungen bzw. nach außen offenen Poren gelangt das Ätzmedium oder ein oder mehrere weitere Ätzmedien an tiefere Bereiche des Substrats. Der in diesem Bereich von dem Ätzmedium bzw. von den weiteren Ätzmedien zersetzte Teil des Halbleitersubstrats wird bevorzugt über die Öffnungen bzw. Poren der Deckschicht und/oder über eine externe Zugangsöffnung zu diesem Bereich entfernt. Die Deckschicht weist vorzugsweise eine Dicke von ca. 2 bis 10 µm, wie insbesondere 3 bis 5 µm, auf. Auf der porösen Deckschicht kann eine weitgehend monokristalline Epitaxieschicht abgeschieden werden.

Im Falle einer Zugangsöffnung wird bevorzugt, anstelle einer porösen Deckschicht von ca. 2 bis 10 µm, eine poröse Deckschicht gebildet, die bevorzugt eine Dicke von ca. 40 bis 80 µm, wie insbesondere 50 bis 60 µm, aufweist. Die größere Dicke hat den Zweck, daß die Deckschicht als Ätz-Pufferschicht beim Ätzen der Zugangsöffnung dienen kann und so einen sicheren Ätzstop vor einer auf der Deckschicht abgeschiedenen weitgehend monokristallinen Epitaxieschicht ermöglicht.

Zur Herstellung eines Halbleiterbauelements mit einer beweglichen Masse bzw. einer Schwingerstruktur, wie zum Beispiel ein Beschleunigungssensor oder ein Drehratensensor, wird die auf der Deckschicht bzw. porösen Deckschicht abgeschiedene weitgehend monokristalline Epitaxieschicht durch ein oder mehrere Vorgänge derart strukturiert, daß aus ihr ganz oder teilweise eine bewegliche Masse bzw. eine Schwingerstruktur des Sensors gebildet wird. Die Strukturierung erfolgt bevorzugt durch die Verwendung von bekannten Trockenätztechniken.

Bei einer bevorzugten Ausführungsform der Erfindung werden in der monokristallinen Epitaxieschicht und/oder in der monokristallinen beweglichen Masse bzw. beweglichen Struktur bzw. Schwingerstruktur, die aus der monokristallinen Epitaxieschicht gebildet worden ist, elektrische und/oder elektronische Halbleiterbauelemente, insbesondere durch geeignete Dotierung, erzeugt. In eine monokristalline Epitaxieschicht bzw. in eine monokristalline bewegliche Masse lassen sich in herkömmlicher Weise elektrische bzw. elektronische Schaltungselemente integrieren.

Eine aus monokristallinem Silizium der Epitaxieschicht gebildete bewegliche Masse bzw. Schwingerstruktur zeichnet sich ggü. einer aus polykristallinem Silizium in bekannter Weise gebildeten Schwingerstruktur dadurch aus, daß eine bewegliche Masse aus monokristallinem Silizium mit einer demgegenüber geringen Schwankungsbreite in den mechanischen Eigenschaften herstellbar ist. Zudem weisen solche, erfindungsgemäß aus monokristallinem Silizium hergestellten Schwingerstrukturen eine hohe Langzeitstabilität auf.

Bei einer bevorzugten Ausführungsform der Erfindung werden beim Ätzvorgang der porösen Deckschicht Maßnahmen ergriffen, die dafür sorgen, daß die Ausdehnungsgeschwindigkeit der Poren in der Deckschicht geringer, vorzugsweise deutlich geringer, als die Ausdehnungsgeschwindigkeit der Poren bzw. Hohlräume in dem Bereich des Substrats ist, der den späteren Hohlraum bzw. die Kaverne bildet.

Dies wird nach einer vorteilhaften Ausführungsform der Erfindung erreicht, indem die Ätzparameter und/oder das oder die Ätzmedien beim Ätzen der Poren in der Deckschicht und die Ätzparameter und/oder das oder die Ätzmedien beim Ätzen der Poren bzw. Hohlräume in dem Bereich der späteren Kaverne unterschiedlich gewählt sind.

Hieran ist insbesondere vorteilhaft, daß die Porosität der Deckschicht zum Abtransport des zur Herstellung der Kaverne zu zersetzenden Siliziums in prozeßtechnisch gut kontrollierbarer Weise bevorzugt lediglich angemessen groß einstellbar ist. Andererseits kann die Kaverne jedoch schnell und damit kostengünstig hergestellt werden.
Nach einer bevorzugten Ausführungsform der Erfindung ist vorgesehen, die Ätzparameter derart einzustellen und/oder das oder die Ätzmedien beim Ätzen der Kaverne derart zu wählen, daß die Ausdehnungsgeschwindigkeit der Poren bzw. Hohlräume derart hoch ist, daß die Poren bzw. Hohlräume sehr rasch miteinander "überlappen". Hierdurch entsteht zunächst ein einziger weitgehend flächenhafter Ausgangshohlraum im Substrat, der sich mit fortschreitender Zeit in die Tiefe ausdehnt und die Kaverne bildet.

Bei einer bevorzugten, zur unmittelbar vorstehenden Ausführungsform alternativen Ausführungsform der Erfindung ist vorgesehen, die Ätzparameter und/oder das oder die Ätzmedien beim Ätzen der Kaverne derart zu wählen, daß die Porosität des Bereichs des Substrats, der die spätere Kaverne bildet, größer als die Porosität der Deckschicht ist. Das Substrat kann insbesondere ein monokristallines Siliziumsubstrat sein. Bevorzugt weist die Vorstufe der späteren Kaverne eine Porosität von mehr als 80 % auf. Vorzugsweise wird die Kaverne nachfolgend aus dem porösen Bereich des Substrats unter Ausführung von einem oder mehreren Temperschritten, vorzugsweise über ca. 900 °C, gebildet.

Bei einer Temperung, bevorzugt unter einer Wasserstoff-Stickstoff- oder Edelgasatmosphäre, wie bei Temperaturen über ca. 900 °C, ordnen sich die Poren im Bereich des Siliziums, der die spätere Kaverne bildet, bei einer Porosität von ca. mehr als 80 % um, wodurch unter der gering porösen Deckschicht bzw. Startschicht für eine nachfolgend abzuscheidende Epitaxieschicht eine einzelne große Pore, also ein Hohlraum bzw. eine Kaverne, entsteht. Die Poren auf der Oberseite der gering porösen Schicht bzw. Startschicht werden bei diesem Hochtemperaturschritt weitgehend verschlossen, so daß auf der Startschicht eine weitgehend monokristalline Siliziumschicht, die eine Ausgangsschicht zur Herstellung von einer oder mehreren beweglichen Massen bildet, abgeschieden werden kann.

Gemäß einer bevorzugten Ausführungsform der Erfindung handelt es sich bei dem Ätzmedium und/oder den Ätzmedien zur Erzeugung der Öffnungen und/oder Poren in der Deckschicht und/oder zur Erzeugung der Kaverne um Flußsäure (HF) oder um eine flüssige Mischung oder eine chemische Verbindung, die Flußsäure enthält.

Bei einer bevorzugten Ausführungsform der Erfindung wird dem Ätzmedium bzw. den Ätzmedien ein leicht flüchtiger Bestandteil, vorzugsweise ein Alkohol, wie z. B. Äthanol, und/oder gereinigtes Wasser zur Verdünnung des Ätzmediums bzw. der Ätzmedien beigegeben.

Äthanol reduziert die Oberflächenspannung eines mit ihm versehenen Ätzmediums, wodurch eine bessere Benetzung der Siliziumoberfläche und ein besseres Eindringen des Ätzmediums in geätzte Poren bzw. Öffnungen bzw. Hohlräume ermöglicht wird. Ferner sind die während des Ätzvorgangs entstehenden Blasen kleiner als ohne die Zugabe von Äthanol zum Ätzmedium und die Blasen können so besser durch die Poren der Deckschicht entweichen. Daher läßt sich die Porengröße und/oder die Porosität der Deckschicht in vorteilhafter Weise kleiner halten als ohne die Zugabe des Alkohols.

Bei einer weiteren bevorzugten Ausführungsform der Erfindung ist vorgesehen, die Öffnungen und/oder Poren in der Deckschicht und/oder im Bereich der späteren Kaverne mit einem elektrochemischen Verfahren, vorzugsweise unter Verwendung des vorgenannten Ätzmediums bzw. der vorgenannten Ätzmedien, zu erzeugen.

Ferner ist bei einer bevorzugten Ausführungsform der Erfindung unter Verwendung eines elektrochemischen Ätzverfahrens, vorzugsweise ein Ätzverfahren unter Verwendung von Flußsäure (HF), vorgesehen, die Ausdehnungsgeschwindigkeit der beim Ätzvorgang entstehenden Poren oder Hohlräume durch das Anlegen einer elektrischen Spannung und eines hierdurch hervorgerufenen elektrischen Stroms durch das Ätzmedium bzw. die Ätzmedien zu beeinflussen. Die Ausdehnungsgeschwindigkeit der Poren bzw. Hohlräume ist insbesondere abhängig von der Dotierung des zu ätzenden Siliziumsubstrats, der Stromdichte, ggf. der HF-Konzentration im Ätzmedium und der Temperatur. Es versteht sich, daß dies lediglich Beispiele relevanter Verfahrensparameter eines erfindungsgemäßen Ätzverfahrens sind.

Nach einer bevorzugten Ausführungsform der Erfindung wird das Ätzmedium, die HF-Konzentration im Ätzmedium und/oder die Dotierung des zu ätzenden Bereichs und/oder die Temperatur und ggf. weitere Prozeßparameter des Ätzverfahrens derart gewählt, daß sich der Ätzvorgang bzw. die Poren- bzw. Hohlraumbildung in geeigneter Weise einstellen und/oder mit dem Ausschalten der elektrischen Spannung abstellen läßt, vorzugsweise weitgehend abrupt.

Bei einem erfindungsgemäß bevorzugten elektrochemischen Ätzverfahren mit einem einzigen Ätzmedium und/oder mit zwei oder mehreren Ätzmedien wird in einem ersten Zeitraum, während dem sich das Ätzmedium im Bereich der Deckschicht befindet, eine erste, nicht notwendigerweise zeitlich konstante Stromdichte im Ätzmedium eingestellt. Während eines zweiten Zeitraums, zu dem sich das betreffende Ätzmedium im Bereich der zu schaffenden Kaverne befindet, wird bevorzugt eine zweite, nicht notwendigerweise zeitlich konstante Stromdichte eingestellt, die höher oder deutlich höher als die oder eine während des ersten Zeitraums eingestellte Stromdichte ist. Hierdurch wird die Kaverne oder ein Vorstadium der Kaverne durch Poren bzw. Hohlräume gebildet, deren Ausdehnungsgeschwindigkeit während des Ätzvorgangs der Kaverne höher oder deutlich höher als die Ausdehnungsgeschwindigkeit der Poren zur Herstellung der porösen Deckschicht ist.

Bei einer weiteren bevorzugten Ausführungsform der Erfindung ist vorgesehen, den porös zu ätzenden Bereich der Deckfläche des Substrats vor dem Ätzvorgang mit einer Maskenschicht bzw. Stützschicht zu umgeben, die einen freien Zugang des Ätzmediums bzw, der Ätzmedien zu dem porös zu ätzenden Bereich gestattet bzw. gestatten und die die nicht porös zu ätzenden Bereiche der Deckfläche des Substrats gegen einen Ätzangriff abschirmt.

Gemäß einer bevorzugten Ausführungsform der Erfindung ist die Stützschicht dergestalt, daß sie den porös zu ätzenden Bereich bzw. die porös zu ätzende Schicht der Deckfläche während und nach dem Ätzen der Kaverne am nicht geätzten Teil des Substrats mechanisch fixiert.

Bei einer bevorzugten Ausführungsform der Erfindung wird die Stützschicht vor dem Ätzen des porös zu ätzenden Bereichs bzw. der zu ätzenden Schicht geschaffen, indem zumindest der nächst umliegende Bereich um die porös zu ätzende Schicht der Deckfläche eines p-dotierten Siliziumsubstrats mit einer n-Dotierung versehen wird. Hierdurch kann ein "Unterätzen" des Substrats insbesondere in dem Bereich weitgehend verhindert werden, in dem die porös geätzte Schicht mit dem Siliziumsubstrat mechanisch verbunden ist. Anderenfalls bestünde die Gefahr, insbesondere bei einer bevorzugt dünnen porösen Schicht bzw. Startschicht, daß diese sich vom Substrat ablöst. Zusätzlich kann eine Siliziumnitrid-Schicht als Maskierung und insbesondere zum Schutz gegen einen Ätzangriff von ggf. darunter liegenden elektronischen Schaltungen verwendet werden.

Alternativ oder ergänzend kann anstelle der n-Dotierung bzw. einer n-dotierten Schicht eine Metallschicht oder Metallmaske vorgesehen sein, die ebenfalls ein Unterätzen des Substrats weitgehend verhindert. Die Verwendung einer Metallschicht bzw. Metallmaske wird jedoch in der Regel nur dann zweckmäßig sein, wenn im Substrat keine Schaltkreise vorgesehen werden sollen, da ansonsten im Substrat auch nach dem Entfernen der Metallschicht bzw. Metallmaske verbleibende Metallatome die Funktion der Schaltkreise beeinträchtigen könnten.

Bei einer weiteren bevorzugten Ausführungsform der Erfindung ist vorgesehen, eine porös geätzte Deckschicht, wie insbesondere eine Siliziumschicht, vorzubehandeln, bevor auf diese eine Epitaxieschicht, vorzugsweise eine weitgehend monokristalline Siliziumschicht, aufgebracht bzw. abgeschieden wird. Die Vorbehandlung verfolgt das Ziel, die Poren in der porös geätzten Deckschicht bzw. Startschicht ganz oder teilweise zu verschließen, um die Qualität der weitgehend monokristallinen Siliziumschicht, falls erforderlich oder zweckmäßig, weiter zu verbessern.

Eine erfindungsgemäße Vorbehandlung kann in einer Temperung der porös geätzten Deckschicht bzw. Startschicht bestehen, wobei die Temperung bei einer hohen Temperatur vorgenommen wird, beispielsweise bei einer Temperatur im Bereich von ca. 900 °C bis ca. 1100 °C. Bevorzugt erfolgt die Temperung unter einer Wasserstoff-, Stickstoff- und/oder einer Edelgasatmosphäre.

Alternativ oder ergänzend zur vorgenannten Vorbehandlung kann eine (geringfügige) Oxidierung der porös geätzten Silizium-Startschicht vorgesehen werden. Bevorzugt erfolgt die Oxidierung unter (geringfügiger) Zugabe von Sauerstoff in die Atmosphäre, der die Startschicht im Reaktor ausgesetzt ist, wobei die Oxidierung bevorzugt bei einer Temperatur im Bereich von etwa 400 °C bis 600 °C erfolgt. Unter geringfügig ist eine Oxidierung zu verstehen, die weitgehend lediglich die Poren der Startschicht ganz oder teilweise verschließt und eine etwa netzartige Oxidstruktur bildet. Die Oxidstruktur soll erfindungsgemäß die Oberfläche der porös geätzten Startschicht möglichst wenig bedecken, um dafür zu sorgen, daß sich auf der Startschicht eine möglichst einkristalline Siliziumschicht abscheiden läßt, aus der nachfolgend, insbesondere durch Trockenätztechniken, vorzugsweise mindestens eine bewegliche Masse gebildet wird. Falls nötig, wird die Oxidierung in einem dem Oxidationsvorgang nachfolgenden Prozeßschritt soweit entfernt, bis dieser erwünschte Zustand eintritt.

Bei einer bevorzugten Ausführungsform der Erfindung ist die Dicke der Startschicht wesentlich kleiner als die Dicke der auf ihr abgeschiedenen Siliziumschicht, so daß das physikalische Verhalten der mindestens einen geschaffen beweglichen Masse bzw. Schwingerstruktur weitgehend durch die prozeßtechnisch gut in ihrer Dicke einstellbare Siliziumschicht bestimmt ist.

Gemäß einer bevorzugten Ausführungsform der Erfindung wird die gering poröse Schicht bzw. Startschicht für die Abscheidung einer Epitaxieschicht mit einem Ätzmedium erzeugt, das eine Flußsäure-Konzentration (HF-Konzentration) im Bereich von ca. 20 % bis ca. 50 %, vorzugsweise ca. 30 % bis ca. 40 %, insbesondere ca. 33 %, aufweist.

Bei einer weiteren bevorzugten Ausführungsform der Erfindung, wird die poröse Schicht, die eine Vorstufe des späteren Hohlraums bzw. der Kaverne bildet, mit einem Ätzmedium geätzt, das eine Flußsäure-Konzentration (HF-Konzentration) im Bereich von ca. 0 % bis ca. 40 %, vorzugsweise ca. 5 % bis ca. 20 %, insbesondere weniger als ca. 20 %, aufweist. Bevorzugt besteht der verbleibende Teil des Ätzmediums, der nicht durch Flußsäure gebildet ist, weitgehend aus einem Alkohol, wie insbesondere Äthanol.

Um während eines vorgenannten erfindungsgemäßen Ätzschritts zur Bildung eines Hohlraums bzw. einer Kaverne eine hohe Ausdehnungsgeschwindigkeit der Poren bzw. Hohlräume in der zu zersetzenden Schicht zu erreichen, bei der die Poren bzw. Hohlräume sehr rasch miteinander "überlappen" und so eine einzige "Riesenpore" bilden, ist bei einer erfindungsgemäßen Ausführungsform der Erfindung ein erfindungsgemäßes Ätzmedium vorgesehen. Das erfindungsgemäße Ätzmedium weist eine Flußsäure-Konzentration (HF-Konzentration) im Bereich von ca. 0 % bis ca. 5 %, vorzugsweise ca. 1 % bis ca. 3 %, insbesondere weniger als ca. 5 % auf. Bevorzugt besteht der verbleibende Teil dieses Ätzmediums, der nicht durch Flußsäure gebildet ist, weitgehend aus einem Alkohol, wie insbesondere Äthanol, und/oder aus gereinigtem Wasser.

### Zeichnungen

Das erfindungsgemäße Verfahren zur Herstellung eines erfindungsgemäßen mehrschichtigen Halbleiterbauelements wird nachfolgend am Beispiel von Beschleunigungssensoren anhand von schematischen, nicht notwendigerweise maßstäblichen Zeichnungen näher erläutert, wobei gleiche Bezugszeichen gleiche oder gleichwirkende Schichten oder Teile bezeichnen. Es zeigt:
- Fig. 1: eine Vorstufe eines bekannten Beschleunigungssensors mit zwei beweglichen Massen bzw. zwei Schwingerstrukturen - im Querschnitt;
- Fig. 2: eine bekannte Vorstufe zur Bildung eines ersten erfindungsgemäßen Beschleunigungssensors - im Querschnitt;
- Fig. 3: eine auf der Grundlage der in Fig. 2 dargestellten bekannten Vorstufe hergestellte weitere Vorstufe des ersten erfindungsgemäßen Beschleunigungssensors mit einer monokristallinen porösen Schicht und einer unter der porösen Schicht gebildeten Kaverne bzw. einem Hohlraum - im Querschnitt;
- Fig. 4: eine weitere Vorstufe des ersten erfindungsgemäßen Beschleunigungssensors, die auf der Grundlage der in Fig. 3 dargestellten Vorstufe hergestellt worden ist, und die eine Epitaxieschicht und in dieser integrierte elektronische Schaltungselemente oder Schaltkreise aufweist - im Querschnitt;
- Fig. 5: eine weitere Vorstufe des ersten erfindungsgemäßen Beschleunigungssensors, die auf der Grundlage der in Fig. 4 dargestellten Vorstufe gebildet worden ist, und die aus der Epitaxieschicht gebildete bewegliche Massen bzw. Schwingerstrukturen aufweist - im Querschnitt;
- Fig. 6: eine Vorstufe eines zweiten erfindungsgemäßen Beschleunigungssensors, der auf der Grundlage der in Fig. 4 dargestellten Vorstufe gebildet worden ist und eine bewegliche Masse bzw. Schwingerstruktur aufweist, deren Beschleunigung oder Auslenkung über piezoresistive Widerstände erfaßt wird - in Draufsicht;
- Fig. 7: eine Vorstufe eines dritten erfindungsgemäßen Beschleunigungssensors, die auf der Grundlage der in Fig. 4 dargestellten Vorstufe hergestellt worden ist und eine bewegliche Masse bzw. Schwingerstruktur aufweist, deren Beschleunigung oder Auslenkung kapazitiv ermittelt wird - im Querschnitt entlang der Linie A-A der Fig. 8;
- Fig. 8: die in Fig. 7 dargestellte Vorstufe des dritten erfindungsgemäßen Beschleunigungssensors mit kapazitiver Auswertung - in Draufsicht;
- Fig. 9: eine auf der Grundlage der in Fig. 2 dargestellten bekannten Vorstufe hergestellte weitere Vorstufe des ersten, zweiten oder dritten erfindungsgemäßen Beschleunigungssensors als Alternative zu der in Fig. 3 dargestellten Vorstufe - im Querschnitt;
- Fig. 10: eine weitere Vorstufe, die auf der Grundlage der in Fig. 9 dargestellten Vorstufe hergestellt worden ist - im Querschnitt; und
- Fig. 11: eine weitere Vorstufe, die auf der Grundlage der in Fig. 10 dargestellten Vorstufe gebildet worden ist-im Querschnitt.

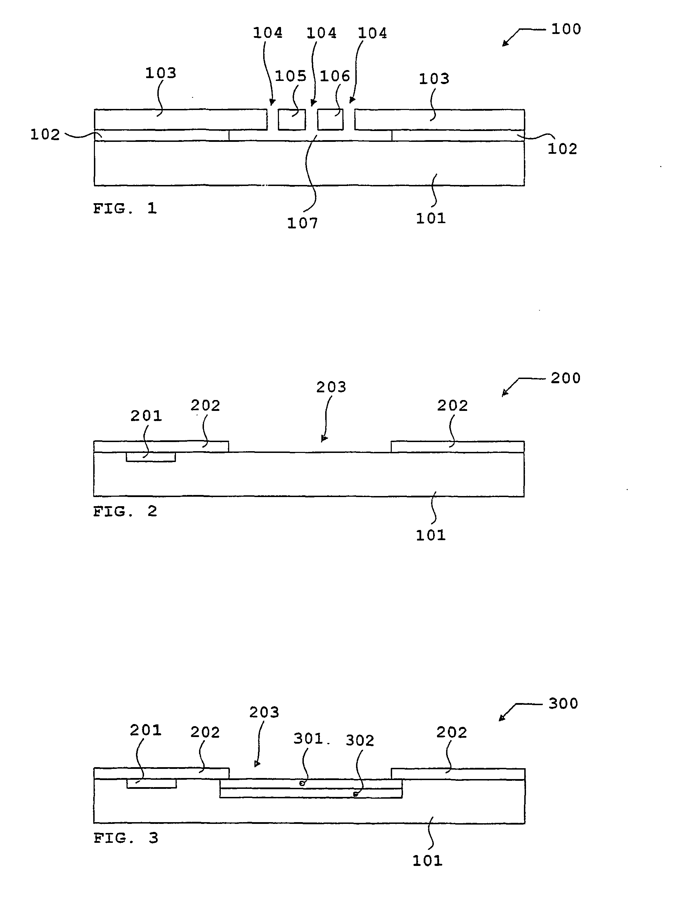

Fig. 1 zeigt die Vorstufe 100 eines bekannten Beschleunigungssensors. Die Vorstufe 100 weist ein Siliziumsubstrat 101 aus monokristallinem Silizium, eine auf dem Siliziumsubstrat 101 abgeschiedene Silizium-Oxid-Opferschicht 102 und eine auf der Silizium-Oxid-Opferschicht 102 abgeschiedene Poly-Siliziumschicht 103 aus polykristallinem Silizium auf. Auf der Vorstufe 100 wird eine Ätzmaske (nicht dargestellt) in bekannter Weise derart aufgebracht, daß die mit dem Bezugszeichen 104 bezeichneten Ätzöffnungen von der Ätzmaske nicht abgedeckt sind. Die Oberseite der in Fig. 1 dargestellten Vorstufe 100 wird nachfolgend in bekannter Weise geätzt, wodurch bewegliche Massen 105 und 106 in der Poly-Siliziumschicht 103 und eine Kaverne bzw. ein Hohlraum 107 in der Silizium-Oxid-Opferschicht 102 gebildet werden bzw. geschaffen wird, wie in Fig. 1 dargestellt.

An diesem Verfahren zur Herstellung der in Fig. 1 dargestellten Vorstufe 100 eines bekannten Beschleunigungssensors ist nachteilig, daß die beweglichen Massen aufgrund der polykristallinen Struktur bei einer Serienproduktion Schwankungen in ihren mechanischen Eigenschaften aufweisen. Zudem weist der Hohlraum große Schwankungen in seinen Abmessungen auf.

Fig. 2 zeigt eine bekannte Vorstufe 200 zur Bildung eines ersten erfindungsgemäßen Beschleunigungssensors - im Querschnitt. Die bekannte Vorstufe 200 weist ein monokristallines Siliziumsubstrat 101, in dem monokristallinen Siliziumsubstrat 101 integrierte elektronische Schaltungselemente bzw. Schaltkreise 201 und eine Ätzmaske 202 auf der Oberseite des monokristallinen Siliziumsubstrats 101 auf, wobei in der Ätzmaske 202 eine Ätzöffnung 203 ausgespart ist.

In Fig. 3 ist eine auf der Grundlage der in Fig. 2 dargestellten bekannten Vorstufe hergestellte weitere Vorstufe 300 des ersten erfindungsgemäßen Beschleunigungssensors dargestellt. Zur Herstellung der Vorstufe 300 aus der in Fig. 2 dargestellten Vorstufe 200 wird der durch die Ätzöffnung 203 definierte Bereich durch die Verwendung eines oder mehrerer Ätzmedien, die Flußsäure aufweisen, elektrochemisch, wie vorstehend eingehend erläutert, porös geätzt. Die Porosität wird durch die Stromdichte im Ätzmedium, die Dotierung des Siliziums und die Zusammensetzung des Ätzmediums gesteuert. Zur Bildung der porösen monokristallinen Siliziumschicht 301 wird der Ätzvorgang so gesteuert, daß die poröse monokristalline Siliziumschicht 101 eine geringe Porosität aufweist. Nachdem die poröse monokristalline Siliziumschicht 301 erzeugt worden ist, wird die Stromdichte in dem Ätzmedium über einen kritischen Wert erhöht und/oder die Zusammensetzung des Ätzmediums verändert, wodurch die "Poren" (nicht dargestellt) unterhalb der porösen Schicht 301 so groß werden, daß das Material des Siliziumsubstrats 101 in dem mit dem Bezugszeichen 302 bezeichneten Bereich komplett herausgeätzt und die Kaverne bzw. der Hohlraum 302 unterhalb der porösen monokristallinen Siliziumschicht 301 erzeugt wird. Das durch das Ätzmedium zersetzte Silizium des Siliziumsubstrats 101 kann über die Poren der porösen Schicht oder auch durch eine separate Zugangsöffnung (nicht dargestellt) abgeführt werden.

Vorteilhafte Maßnahmen zur Herstellung der porösen Schicht 301 und des unter der porösen Schicht 301 gebildeten Hohlraums 302 sind vorstehend detailliert erläutert worden, so daß an dieser Stelle hierauf lediglich Bezug genommen wird.

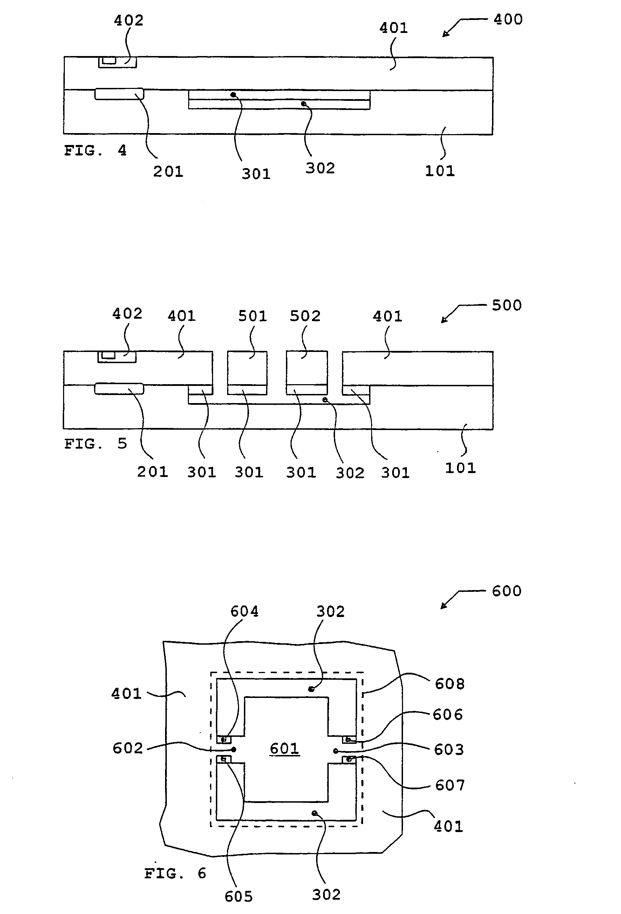

Fig. 4 zeigt eine weitere Vorstufe 400 des ersten erfindungsgemäßen Beschleunigungssensors, die auf der Grundlage der in Fig. 3 dargestellten Vorstufe 300 hergestellt worden ist. Die Vorstufe 400 weist das Siliziumsubstrat 101, die in dem Siliziumsubstrat 101 integrierten elektronischen Schaltungselemente bzw. Schaltkreise 201, die poröse monokristalline Siliziumschicht 301 und die Kaverne bzw. den Hohlraum 302 auf. Auf der porösen monokristallinen Siliziumschicht 301 ist eine monokristalline Silizium-Epitaxieschicht 401 abgeschieden worden. Die Abscheidung einer monokristallinen Silizium-Epitaxieschicht auf der erfindungsgemäßen porösen monokristallinen Siliziumschicht 301 ist dadurch ermöglicht, daß bei geeignet geringer Porosität der porösen Siliziumschicht 301 eine weitgehend monokristalline Epitaxieschicht auf der porösen monokristallinen Siliziumschicht 301 abgeschieden werden kann. Die monokristalline Silizium-Epitaxieschicht 401 verschließt die Kaverne bzw. den Hohlraum 302, wobei der Druck, der beim Epitaxieprozeß zur Abscheidung der monokristallinen Silizium-Epitaxieschicht 401 herrscht, den im Hohlraum 302 eingeschlossenen Druck bestimmt. Bei dem in Fig. 4 dargestellten Beispiel sind mit Standard-Halbleiterprozessen weitere elektronische Schaltungselemente bzw. Schaltkreise 402 oder dergleichen, z. B. durch geeignete Dotierung der monokristallinen Silizium-Epitaxieschicht 401, erzeugt worden.

Zur Verbesserung der Qualität der monokristallinen Silizium-Epitaxieschicht 401 kann die poröse monokristalline Siliziumschicht 301 erforderlichenfalls vorbehandelt werden, wie vorstehend bereits erläutert.
Fig. 5 zeigt eine weitere Vorstufe 500 des ersten erfindungsgemäßen Beschleunigungssensors, die auf der Grundlage der in Fig. 4 dargestellten Vorstufe 400 gebildet worden ist.

Die Vorstufe 500 weist das Siliziumsubstrat 101, die in dem Siliziumsubstrat 101 integrierten elektronischen Schaltungselemente bzw. Schaltkreise 201, die Kaverne bzw. den Hohlraum 302 und zwei bewegliche Massen 501 und 502 auf, die vorzugsweise durch bekannte Trockenätztechniken aus der monokristallinen Silizium-Epitaxieschicht 401 und der porösen monokristallinen Siliziumschicht 301 gebildet worden sind. Ferner sind in der monokristallinen Silizium-Epitaxieschicht 401 elektronische Schaltungselemente bzw. Schaltkreise 402 durch entsprechende Standard-Halbleiterverfahren, wie insbesondere durch geeignete Dotierung, integriert worden.

Vergleicht man die in Fig. 1 dargestellte Vorstufe 100 eines bekannten Beschleunigungssensors mit zwei beweglichen Massen 105 und 106 mit der in Fig. 5. dargestellten Vorstufe 500 eines ersten erfindungsgemäßen Beschleunigungssensors, so fällt auf, daß die beweglichen Massen 501 und 502 - im Unterschied zu den beweglichen Massen 105 und 106 aus PolySilizium - aus monokristallinem Silizium der monokristallinen Silizium-Epitaxieschicht 401 und geringfügig auch aus der porösen monokristallinen Siliziumschicht 301 gebildet worden sind. Aufgrund der definierten Materialparameter bei monokristallinem Silizium lassen sich erfindungsgemäß bewegliche Massen 501 und 502 in reproduzierbarer Weise bei geringen Schwankungen in ihren mechanischen Eigenschaften bilden. Zudem können in die monokristalline Silizium-Epitaxieschicht 401 der Vorstufe 500 elektronische Schaltungselemente bzw. Schaltkreise 402 integriert werden, was bei einer Poly-Siliziumschicht 103 unter Verwendung von Standard-Halbleiterprozessen nicht möglich ist.

Die Auswertung von Bewegungen der beweglichen Massen bzw. Schwingerstrukturen 501 und 502 und ggf. weiterer Massen (nicht dargestellt) kann beispielsweise kapazitiv erfolgen. Für eine kapazitive Auswertung werden die beweglichen Massen 501 und 502 (und vorzugsweise auch weitere nicht dargestellte bewegliche Massen) bevorzugt in Form von Interdigitalstrukturen aus der monokristallinen Silizium-Epitaxieschicht 401 gebildet. Unter Interdigitalstrukturen sollen insbesondere solche Strukturen verstanden werden, die mindestens aus einer ersten Struktur und einer zweiten Struktur bestehen. Die erste und zweite Struktur weist jeweils eine Vielzahl von fingerförmigen, teilweise beweglichen Massen auf, wobei jeweils ein Finger der ersten Struktur zwischen zwei benachbarten Fingern der zweiten Struktur angeordnet ist. Die erste Struktur bildet eine erste feststehende Kondensatorplatte und die zweite Struktur eine zweite, bewegliche Kondensatorplatte. Solche Interdigitalstrukturen weisen eine hohe Empfindlichkeit zur Ermittlung von Beschleunigungen auf, die auf die zweite Struktur einwirken.

Alternativ können jedoch auch piezoresistive Widerstände an den beweglichen Massen 501 und 502 sowie weiteren Massen (nicht dargestellt) zur Ermittlung der Beschleunigung bzw. der Auslenkung der beweglichen Massen bzw. Schwingerstrukturen vorgesehen sein. Weiterhin ist es möglich in der in Fig. 5 dargestellten Vorstufe 500 einen Kondensator (nicht dargestellt) vorzusehen, der die beweglichen Massen 501 und 502 durch Anlegen einer elektrischen Spannung gezielt auslenkt, z. B. zu Testzwecken. Diese Auslenkung bzw. Beschleunigung wird dann in der vorgenannten Weise kapazitiv oder piezoresistiv ermittelt.

Fig. 6 zeigt eine Vorstufe 600 eines zweiten erfindungsgemäßen Beschleunigungssensors, der auf der Grundlage der in Fig. 4 dargestellten Vorstufe 400 gebildet worden ist - in Draufsicht. Die Vorstufe 600 des zweiten erfindungsgemäßen Beschleunigungssensors weist im Unterschied zu der in Fig. 5 dargestellten Vorstufe 500 eines ersten erfindungsgemäßen Beschleunigungssensors eine einzige - im Verhältnis zu den Massen 501 und 502 - großflächige bewegliche Masse 601 auf, die über Befestigungarme 602 und 603 mit der monokristallinen Silizium-Epitaxieschicht 401 verbunden ist. Unterhalb der großflächigen beweglichen Masse 601 befindet sich die Kaverne bzw. der Hohlraum 302. Die bewegliche Masse 601 ist durch eine entsprechende Gestaltung der Befestigungarme 602 und 603 an der monokristallinen Silizium-Epitaxieschicht 401 federnd aufgehängt, so daß die großflächige bewegliche Masse 601 sowohl in X-Richtung, d. h. in Richtung des oberen bzw. unteren Blattrands als auch in Z-Richtung, d. h. in die Blattebene hinein und aus dieser heraus, schwingen kann. In vorteilhafter Weise läßt sich mittels der in Fig. 6 dargestellten Vorstufe 600 ein Beschleunigungssensor realisieren, der sowohl in X-Richtung als auch in Z-Richtung Beschleunigungen und damit einhergehende Auslenkungen der großflächigen beweglichen Masse 601 erfaßt. Die Auswertung der Auslenkung bzw. der Beschleunigung der großflächigen beweglichen Masse 601 erfolgt über piezoresistive Widerstände 604 bis 607, wobei die piezoresistiven Widerstände 604 und 605 im Befestigungsarm 602, der als erste federnde Aufhängung der beweglichen Masse 601 dient, und die piezoresistiven Widerstände 606 und 607 in dem zweiten Befestigungsarm 603, der als zweite federnde Aufhängung der beweglichen Masse 601 dient, angeordnet sind. Die gestrichelte Linie 608 zeigt die Kante des Bereichs, der porös geätzt worden ist, d. h. die Kante der porösen monokristallinen Siliziumschicht 301, die an das Siliziumsubstrat 101 angrenzt.

Wird die großflächige bewegliche Masse 601 in X-Richtung beschleunigt, d. h. in Richtung des oberen oder unteren Blattrands, so erfahren die beiden oberen piezoresistiven Widerstände 604 und 606 die gleiche Widerstandsänderung, die entgegengesetzt zur Widerstandsänderung der beiden unteren piezoresistiven Widerstände 605 und 607 ist. Wird die großflächige bewegliche Masse 601 in Z-Richtung beschleunigt, d. h. in die Blattebene hinein oder aus dieser heraus, so erfahren alle piezoresistiven Widerstände 604, 605, 606, und 607 die gleiche Widerstandsänderung. Beispielsweise können die piezoresistiven Widerstände zur Erfassung der Beschleunigung bzw. der Auslenkung der großflächigen beweglichen Masse 601 zu einer Wheatstoneschen Brücke verschaltet werden.

Die großflächige bewegliche Masse 601, die aus monokristallinem Silizium der monokristallinen Silizium-Epitaxieschicht 401 besteht, kann aus dieser durch bekannte Trockenätztechniken, wie insbesondere durch Trenchätzen, erzeugt werden.

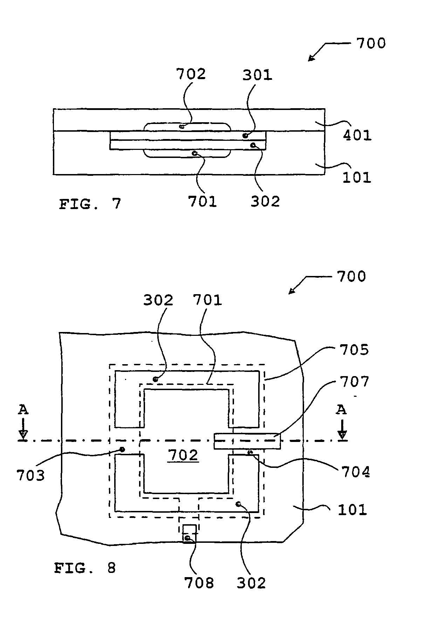

In Fig. 7 ist eine Vorstufe 700 eines dritten erfindungsgemäßen Beschleunigungssensors dargestellt, die auf der Grundlage der in Fig. 4 dargestellten Vorstufe 400 hergestellt worden ist. - im Querschnitt entlang der Linie A - A der Fig. 8. Die Vorstufe 700 des dritten erfindungsgemäßen Beschleunigungssensors weist das Siliziumsubstrat 101, eine Bodenelektrode 701, eine Kaverne bzw. einen Hohlraum 302, eine poröse monokristalline Siliziumschicht 301, eine monokristalline Silizium-Epitaxieschicht 401 und eine Deckelelektrode 702 auf. Die Bodenelektrode 701 besteht aus einem dotierten Bereich, dessen Dotierung vor dem porösen Ätzen des Siliziumsubstrats 101 in das Siliziumsubstrat 101 eingebracht worden ist. Vorzugsweise reicht der dotierte Bereich, der die Bodenelektrode 701 bildet, tiefer in das Siliziumsubstrat 101 hinein als der porös geätzte Bereich bzw. die poröse monokristalline Siliziumschicht 301. Die Deckelelektrode 702 wird durch einen dotierten Bereich gebildet, dessen Dotierung vor der Abscheidung der monokristallinen Silizium-Epitaxieschicht 401 vorgenommen wird.

Fig. 8 zeigt die in Fig. 7 dargestellte Vorstufe 700 des dritten erfindungsgemäßen Beschleunigungssensors - in Draufsicht. Die Draufsicht 800 der Vorstufe 700 zeigt die Deckelelektrode 702, die eine - im Verhältnis zu den Massen 501 und 502 - großflächige bewegliche Masse darstellt. Die Deckelelektrode 702 ist an Befestigungsarmen 703 und 704 am Siliziumsubstrat 101 federelastisch aufgehängt. Die äußere gestrichelte Linie 705 zeigt die Kante des porös geätzten Bereichs 302, die an das Siliziumsubstrat 101 angrenzt. Die innere gestrichelte Linie 706 zeigt die unter der Deckelelektrode 702 befindliche (an sich verdeckte) Bodenelektrode 701, die in dem Siliziumsubstrat 101 vorgesehen ist. Zur Erfassung der Bewegungen der Deckelelektrode infolge einer auf die Deckelelektrode einwirkenden Beschleunigung und einer damit einhergehenden Kapazitätsänderung zwischen der Deckelelektrode und der Bodenelektrode, die einen Kondensator bilden, ist ein elektrischer Anschluß 707 vorgesehen, der sich von der Deckelelektrode 702 über den Befestigungsarm 704 bis zum Siliziumsubstrat 101 erstreckt. Ferner ist ein Anschluß 708 vorgesehen, der die Bodenelektrode 701 kontaktiert und auf das Siliziumsubstrat 101 geführt ist. Die Anschlüsse 707 und 708 werden vorzugsweise durch geeignet dotierte Bereiche in der monokristallinen Silizium-Epitaxieschicht 401 und in dem Siliziumsubstrat 101 gebildet. Die Deckelelektrode 702 ist gegenüber der feststehenden Bodenelektrode 701 in Z-Richtung, d. h. in die Blattebene hinein und aus dieser heraus, bei der Einwirkung einer Beschleunigung auf die Deckelelektrode bzw. den dritten erfindungsgemäßen Beschleunigungssensor auslenkbar. Die Auslenkung bzw. Beschleunigung der Deckelelektrode kann über die Kondensatoranordnung, die durch die Deckelelektrode und die Bodenelektrode gebildet ist, kapazitiv erfaßt bzw. ausgewertet werden.

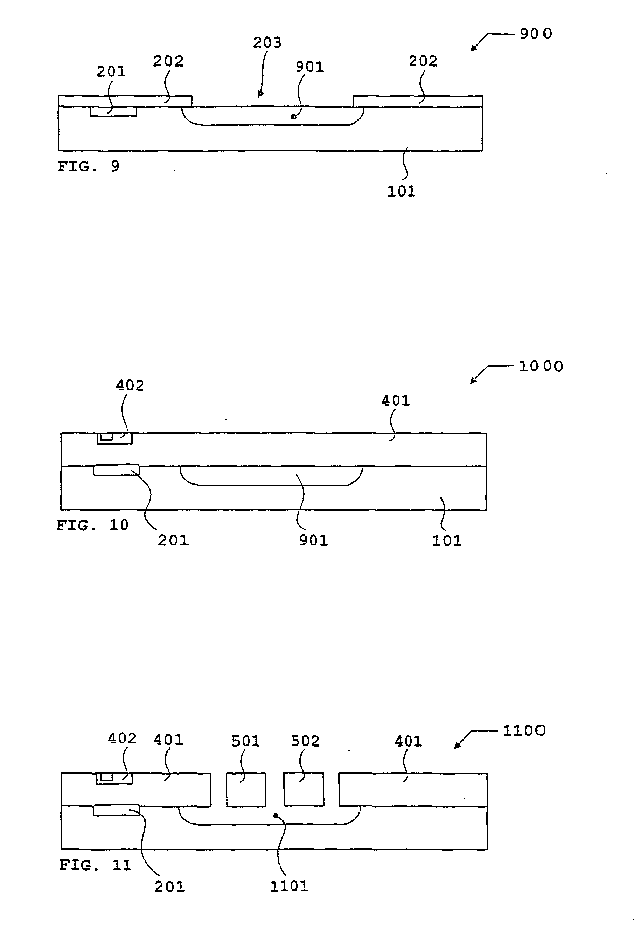

Fig. 9 stellt eine bevorzugte Alternative zu der in Fig. 3 dargestellten Vorstufe 300 für den ersten, zweiten oder dritten erfindungsgemäßen Beschleunigungssensor dar. Die in Fig. 9 dargestellte Vorstufe 900 weist im Unterschied zu der in Fig. 3 dargestellten Vorstufe eine poröse monokristalline Siliziumschicht 901 auf, deren Dicke weitgehend der Gesamtdicke der Kombination aus der monokristallinen Siliziumschicht 301 und der Kaverne bzw. dem Hohlraum 302 entspricht. Die poröse monokristalline Siliziumschicht 901 kann bspw. durch die vorstehend detailliert erläuterten Maßnahmen gebildet werden.

Die in Fig. 10 dargestellte Alternative zu der in Fig. 4 dargestellten Vorstufe 400 für die Bildung des ersten, zweiten oder dritten erfindungsgemäßen Beschleunigungssensors unterscheidet sich von der in Fig. 4 dargestellten Vorstufe 400 darin, daß die Epitaxieschicht 401 auf der porösen monokristallinen Siliziumschicht 901 und der Oberseite des monokristallinen Siliziumsubstrats 101 der Vorstufe 900 abgeschieden worden ist.

Die in Fig. 11 dargestellte Alternative zu der in Fig. 5 dargestellten Vorstufe 500 unterscheidet sich von der in Fig. 5 dargestellten Vorstufe 500 darin, daß die poröse monokristalline Siliziumschicht 901 der Vorstufe 1000 bei der im Zusammenhang mit der Fig. 5 beschriebenen Bildung der beweglichen Massen 501 und 502 entfernt bzw. weggeätzt wird. Durch die Entfernung der porösen monokristallinen Siliziumschicht 901 entsteht eine Kaverne bzw. ein Hohlraum 1101.

Die in den Figuren 9 bis 11 dargestellten Alternativen zu den in den Figuren 3 bis 5 dargestellten Vorstufen haben demgegenüber den Vorteil, daß der Gesamtaufwand zur Herstellung der beweglichen Massen 501 und 502 sowie der Kaverne bzw. des Hohlraums 1101 durch die vorstehend beschriebenen Maßnahmen verringert wird. Zur Bildung der in Fig. 11 dargestellten Kaverne bzw. des Hohlraums 1101 ist es nicht mehr notwendig die Ätzparameter so einzustellen, daß zunächst eine poröse monokristalline Siliziumschicht 101 und dann, durch Änderung der Ätzparameter, eine Kaverne bzw. ein Hohlraum 102 gebildet wird. Vielmehr kann ohne Änderung der Ätzparameter die gesamte poröse monokristalline Siliziumschicht 901 gebildet werden, die bei der beschriebenen Ätzung bzw. Bildung der beweglichen Massen 501 und 502 aus der Epitaxieschicht 401 mitentfernt bzw. weggeätzt wird.

## Patentansprüche

1. Verfahren zur Herstellung eines mikromechanischen Bauelements (300; 400; 500; 600; 700; 800; 900; 1000; 1100), wie insbesondere ein Beschleunigungssensor oder ein Drehratensensor, das ein Halbleitersubstrat (101) aufweist, wie insbesondere aus Silizium,
**dadurch gekennzeichnet,**
**dass** in einem ersten Schritt eine erste poröse Schicht (301; 901) in dem Halbleiterbauelement gebildet wird;
**dass** in einem zweiten Schritt ein Hohlraum bzw. eine Kaverne (302; 1101) unter der ersten porösen Schicht (301) in dem Halbleiterbauelement gebildet wird; und
**dass** auf der ersten porösen Schicht (301) eine Epitaxieschicht (401), wie beispielsweise eine Siliziumschicht, abgeschieden wird, die vorzugsweise monokristallin ist.

2. Verfahren nach Anspruch 1, **dadurch gekennzeichnet, dass** der zweite Schritt einen ersten Unterschritt aufweist, während dem unter der ersten porösen Schicht (301) eine zweite poröse Schicht (302) mit einer Porosität von mehr als ca. 70% und weniger als 100%, vorzugsweise ca. 85 bis 95%, gebildet wird.

3. Verfahren nach Anspruch 2, **dadurch gekennzeichnet, dass** der Hohlraum bzw. die Kaverne (302) durch einen Temperschritt aus der zweiten porösen Schicht gebildet wird.

4. Verfahren nach Anspruch 1, **dadurch gekennzeichnet, dass** der zweite Schritt einen ersten Unterschritt aufweist, während dem unter der ersten porösen Schicht (301) ein zunächst flächenhafter Hohlraum gebildet wird, und sich der zunächst flächenhafte Hohlraum in die Tiefe ausdehnt und so aus dem zunächst flächenhaften Hohlraum der Hohlraum bzw. die Kaverne (302) entsteht.

5. Verfahren nach einem der Ansprüche 1 bis 4, **dadurch gekennzeichnet, dass** die erste und/oder zweite poröse Schicht (301, 302; 901) durch ein oder mehrere Ätzmedien gebildet wird bzw. gebildet werden, wobei das Ätzmedium und/oder die Ätzmedien vorzugsweise Flusssäure, HF-Säure, aufweisen oder aus Flusssäure bestehen.

6. Verfahren nach Anspruch 5, **dadurch gekennzeichnet, dass** das Ätzmedium bzw. die Ätzmedien mit einem oder mehreren Zusätzen versehen ist bzw. sind, wie Zusätzen zur Verringerung der Blasenbildung, zur Verbesserung der Benetzung und/oder zur Verbesserung der Trocknung, wie insbesondere ein Alkohol, wie beispielsweise Äthanol, wobei die Volumenkonzentration des Zusatzes, wie insbesondere Äthanol, bei Äthanol vorzugsweise ca. 60% bis ca. 100%, beträgt.

7. Verfahren nach einem der Ansprüche 1 bis 6, **dadurch gekennzeichnet, dass** die erste und/oder zweite poröse Schicht (301, 302; 901) unter Anlegen eines elektrischen Feldes zwischen der Oberseite und der Unterseite des Halbleiterbauelements (300; 400; 500; 600; 700; 800) und der Einstellung eines elektrischen Stroms gebildet wird.

8. Verfahren nach einem der Ansprüche 1 bis 7, **dadurch gekennzeichnet, dass** die Verfahrensparameter zur Bildung der zweiten porösen Schicht (302) bzw. zur Bildung des zunächst flächenhaften Hohlraums derart gewählt werden, dass die Ausdehnungsgeschwindigkeit der Poren bzw. Hohlräume in der zweiten porösen Schicht deutlich höher ist als die Ausdehnungsgeschwindigkeit der Poren bzw. Hohlräume zur Bildung der ersten porösen Schicht (301).

9. Verfahren nach einem der Ansprüche 4 bis 8, **dadurch gekennzeichnet, dass** die Verfahrensparameter zur Bildung des zunächst flächenhaften Hohlraums derart gewählt werden, dass die Poren bzw. Hohlräume der zweiten porösen Schicht (302) einander in lateraler Richtung "überlappen" und so eine einzige zunächst flächenhafte Pore bzw. ein einziger zunächst flächenhafter Hohlraum gebildet wird.

10. Verfahren nach einem der Ansprüche 5 bis 9, **dadurch gekennzeichnet, dass** die Dotierung des zu ätzenden Halbleitersubstrats (101), wie insbesondere ein Siliziumsubstrat, die Stromdichte in dem Ätzmedium bzw. in den Ätzmedien, die Flusssäure-Konzentration in dem Ätzmedium bzw. in den Ätzmedien, ein oder mehrere Zusätze zum Ätzmedium bzw. zu den Ätzmedien und die Temperatur Verfahrensparameter darstellen.

11. Verfahren nach einem der Ansprüche 1 bis 10, **dadurch gekennzeichnet, dass** die Epitaxieschicht (401) derart strukturiert wird, dass aus ihr ganz oder teilweise mindestens eine bewegliche Masse (501, 502; 601; 702) gebildet wird, wie insbesondere die Schwingerstruktur eines Beschleunigungssensors oder eines Drehratensensors.

12. Verfahren nach Anspruch 11, **dadurch gekennzeichnet, dass** die erste poröse Schicht (301; 901) bei der Bildung der mindestens einen beweglichen Masse (501, 502; 601; 702) entfernt wird.

13. Mikromechanisches Bauelement (300; 400; 500; 600; 700; 800; 900; 1000; 1100), wie insbesondere ein Beschleunigungssensor oder ein Drehratensensor, mit einem Halbleitersubstrat (101), wie insbesondere aus Silizium, **dadurch gekennzeichnet, dass** es nach einem Verfahren nach einem oder mehreren der Ansprüche 1 bis 12 hergestellt worden ist.

14. Mikromechanisches Bauelement nach Anspruch 13, **dadurch gekennzeichnet, dass** auf oder oberhalb der porösen Schicht (301; 901) eine monokristalline Schicht (401), wie insbesondere eine monokristalline Siliziumschicht, angeordnet ist, wobei die monokristalline Schicht (401) mit mindestens einem elektrischen und/oder elektronischen Schaltungselement (402) versehen und/oder derart strukturiert ist, dass die monokristalline Schicht (401) eine bewegliche Masse (501, 502; 601, 702), wie insbesondere die Schwingerstruktur eines Beschleunigungssensors oder eines Drehratensensors, aufweist.

15. Mikromechanisches Bauelement nach Anspruch 14, **dadurch gekennzeichnet, dass** die bewegliche Masse (601; 702) mit mindestens einem elektrischen und/oder elektronischen Schaltungselement (604, 605, 606, 607; 707, 708) versehen ist.

## Claims

1. Process for producing a micromechanical component (300; 400; 500; 600; 700; 800; 900; 1000; 1100), such as in particular an acceleration sensor or a rotation rate sensor, which has a semiconductor substrate (101), such as in particular made from silicon,
**characterized**
**in that** in a first step a first porous layer (301; 901) is formed in the semiconductor component;
**in that** in a second step a void or cavity (302; 1101) is formed beneath the first porous layer (301) in the semiconductor component; and
**in that** an epitaxial layer (401), such as for example a silicon layer, which is preferably monocrystalline, is deposited on the first porous layer (301).

2. Process according to Claim 1, **characterized in that** the second step includes a first substep, during which a second porous layer (302) with a porosity of more than approx. 70% and less than 100%, preferably approx. 85 to 95%, is formed beneath the first porous layer (301).

3. Process according to Claim 2, **characterized in that** the void or cavity (302) is formed from the second porous layer by a conditioning step.

4. Process according to Claim 1, **characterized in that** the second step includes a first substep, during which an initially superficial void is formed beneath the first porous layer (301), and the initially superficial void expands into the depth and in this way the void or cavity (302) is formed from the initially superficial void.

5. Process according to one of Claims 1 to 4, **characterized in that** the first and/or second porous layer (301, 302; 901) is/are formed by one or more etching media, the etching medium and/or etching media preferably including hydrofluoric acid, HF acid, or consisting of hydrofluoric acid.

6. Process according to Claim 5, **characterized in that** the etching medium or etching media is/are provided with one or more additives, such as additives for reducing the formation of bubbles, for improving the wetting and/or for improving the drying, such as in particular an alcohol, such as for example ethanol, the concentration by volume of the additive, such as in particular ethanol, being preferably approx. 60% to approx. 100% in the case of ethanol.

7. Process according to one of Claims 1 to 6, **characterized in that** the first and/or second porous layer (301, 302; 901) is formed with the application of an electric field between the top side and the underside of the semiconductor component (300; 400; 500; 600; 700; 800) and the setting of an electric current.

8. Process according to one of Claims 1 to 7, **characterized in that** the process parameters used to form the second porous layer (302) and/or to form the initially superficial void are selected in such a manner that the expansion rate of the pores or voids in the second porous layer is significantly higher than the expansion rate of the pores or voids used to form the first porous layer (301).

9. Process according to one of Claims 4 to 8, **characterized in that** the process parameters used to form the initially superficial void are selected in such a manner that the pores or voids of the second porous layer (302) "overlap" one another in the lateral direction, and in this way a single, initially superficial pore or a single, initially superficial void is formed.

10. Process according to one of Claims 5 to 9, **characterized in that** the doping of the semiconductor substrate (101) that is to be etched, such as in particular a silicon substrate, the current density in the etching medium or etching media, the hydrofluoric acid concentration in the etching medium or etching media, one or more additives to the etching medium or etching media and the temperature represent process parameters.

11. Process according to one of Claims 1 to 10, **characterized in that** the epitaxial layer (401) is patterned in such a manner that at least one moving mass (501, 502; 601; 702), such as in particular the oscillator structure of an acceleration sensor or a rotation rate sensor, is formed completely or partially from it.

12. Process according to Claim 11, **characterized in that** the first porous layer (301; 901) is removed during the formation of the at least one moving mass (501, 502; 601; 702).

13. Micromechanical component (300; 400; 500; 600; 700; 800; 900; 1000; 1100), such as in particular an acceleration sensor or a rotation rate sensor, having a semiconductor substrate (101), such as in particular made from silicon, **characterized in that** it has been produced by a process according to one or more of Claims 1 to 12.

14. Micromechanical component according to Claim 13, **characterized in that** a monocrystalline layer (401), such as in particular a monocrystalline silicon layer, is arranged on or above the porous layer (301; 901), the monocrystalline layer (401) being provided with at least one electrical and/or electronic switching element (402) and/or being patterned in such a manner that the monocrystalline layer (401) has a moving mass (501, 502; 601, 702), such as in particular the oscillator structure of an acceleration sensor or a rotation rate sensor.

15. Micromechanical component according to Claim 14, **characterized in that** the moving mass (601; 702) is provided with at least one electrical and/or electronic switching element (604, 605, 606, 607; 707, 708).

## Revendications

1. Procédé de fabrication d'un composant micromécanique (300 ; 400 ; 500 ; 600 ; 700 ; 800 ; 900 ; 1000 ; 1100), tel que notamment un capteur d'accélération ou un capteur de vitesse de rotation, qui présente un substrat semi-conducteur (101), tel que notamment une base silicium,
**caractérisé en ce que**
dans une première étape, on forme une première couche poreuse (301 ; 901) dans le composant semi-conducteur ;
dans une seconde étape, on forme une cavité et/ou une caverne (302 ; 1101) dans le composant semi-conducteur sous la première couche poreuse (301) ; et
sur la première couche poreuse (301) ont dépose une couche épitaxiale (401), telle que par exemple une couche de silicium, de préférence monocristalline.

2. Procédé selon la revendication 1,
**caractérisé en ce que**
la seconde étape présente une première sous-étape pendant laquelle on forme sous la première couche poreuse (301), une seconde couche poreuse (302) ayant une porosité supérieure à environ 70 % et inférieure à 100 %, de préférence d'environ 85 à 95 %.

3. Procédé selon la revendication 2,
**caractérisé en ce que**
la cavité et/ou la caverne (302) est formée par une étape de recuit à partir de la seconde couche poreuse.

4. Procédé selon la revendication 1,
**caractérisé en ce que**
la seconde étape présente une première sous-étape pendant laquelle un espace creux d'abord superficiel est formé sous la première couche poreuse (301), et l'espace creux d'abord superficiel s'étend en profondeur pour former ainsi à partir de l'espace creux d'abord superficiel la cavité ou la caverne (302).

5. Procédé selon l'une quelconque des revendications 1 à 4,
**caractérisé en ce que**
la première et/ou la seconde couche poreuse (301, 302 ; 901) est formée ou sont formées par un ou plusieurs moyens de corrosion, le et/ou les moyens de corrosion comportant, de préférence, l'acide fluorhydrique, l'acide fluorhydrique (HF), ou se composant d'acide fluorhydrique.

6. Procédé selon la revendication 5,
**caractérisé en ce que**
le et/ou les moyens de corrosion est ou sont pourvu(s) d'un ou plusieurs additifs, tel(s) que des additifs destinés à réduire la formation de bulles, à améliorer le mouillage et/ou le séchage, tel(s) que notamment un alcool, comme, par exemple, l'éthanol, la concentration en volume de l'additif, tel que, notamment l'éthanol, allant de préférence pour l'éthanol, d'environ 60 % à environ 100 %.

7. Procédé selon l'une quelconque des revendications 1 à 6,
**caractérisé en ce que**
la première et/ou la seconde couche poreuse (301, 302 ; 901) est formée en appliquant un champ électrique entre la face supérieure et la face inférieure du composant semi-conducteur (300 ; 400 ; 500 ; 600 ; 700 ; 800) et en réglant un courant électrique.

8. Procédé selon l'une quelconque des revendications 1 à 7,
**caractérisé en ce que**
les paramètres du procédé permettant de former la seconde couche poreuse (302) et/ou l'espace creux d'abord superficiel sont choisis de telle manière que la vitesse de dilatation des pores et/ou des cavités est nettement plus élevée dans la seconde couche poreuse que la vitesse de dilatation des pores ou des cavités permettant de former la première couche poreuse (301).

9. Procédé selon l'une quelconque des revendications 4 à 8,
**caractérisé en ce que**
les paramètres du procédé permettant de former l'espace creux d'abord superficiel sont choisis pour que les pores ou les cavités de la seconde couche poreuse (302) se « chevauchent » dans la direction latérale et qu'un seul pore d'abord superficiel ou un seul espace creux d'abord superficiel soit ainsi formé.

10. Procédé selon l'une quelconque des revendications 5 à 9,
**caractérisé en ce que**
les paramètres du procédé sont le dopage du substrat semi-conducteur (101) à corroder, tel que, notamment un substrat de silicium, la densité du courant dans le ou les moyens de corrosion, la concentration d'acide fluorhydrique dans le ou les moyens de corrosion, un ou plusieurs additifs du ou des moyens de corrosion et la température.

11. Procédé selon l'une quelconque des revendications 1 à 10,
**caractérisé en ce qu'**
on structure la couche épitaxiale (401) pour former totalement ou partiellement à partir de cette dernière au moins une masse mobile (501, 502 ; 601 ; 702) telle que, notamment la structure de l'oscillateur d'un capteur d'accélération ou d'un capteur de vitesse de rotation.

12. Procédé selon la revendication 11,
**caractérisé en ce qu'**
on retire la première couche poreuse (301 ; 901) lors de la formation d'au moins une masse mobile (501, 502 ; 601 ; 702).

13. Composant micromécanique (300 ; 400 ; 500 ; 600 ; 700 ; 800 ; 900 ; 1000 ; 1100), tel que notamment un capteur d'accélération ou un capteur de vitesse de rotation, muni d'un substrat semi-conducteur (101), tel que notamment une base de silicium,
**caractérisé en ce qu'**
il a été fabriqué selon un procédé selon une ou plusieurs des revendications 1 à 12.

14. Composant micromécanique selon la revendication 13,
**caractérisé en ce que**
sur ou au-dessus de la couche poreuse (301 ; 901) est formée une couche monocristalline (401), telle que, notamment une couche de silicium monocristalline (401) munie d'au moins un élément de couplage électrique et/ou électronique (402), et/ou structurée de telle manière que la couche monocristalline (401) présente une masse mobile (501, 502 ; 601, 702), telle que notamment la structure de l'oscillateur d'un capteur d'accélération ou d'un capteur de vitesse de rotation.

15. Composant micromécanique selon la revendication 14,
**caractérisé en ce que**
la masse mobile (601 ; 702) est munie d'au moins un élément de couplage électrique et/ou électronique (604, 605, 606, 607 ; 707, 708).
